# FASCICULE DE BREVET EUROPEEN

(11) **EP 1 299 902 B1**
(45) Date de publication et mention de la délivrance du brevet: **26.06.2019**
(21) Numéro de dépôt: 01953196.1
(22) Date de dépôt: 06.07.2001
(51) Int. Cl.: H01L 21/28, H01L 29/423, H01L 29/49

(54) **PROCEDE DE REALISATION D'UNE GRILLE POUR UNE STRUCTURE DE TRANSISTOR CMOS A CANAL DE LONGUEUR REDUITE**
HERSTELLUNGSVERFAHREN FÜR EIN GATE FÜR EINE CMOS TRANSISTORSTRUKTUR MIT REDUZIERTER KANALLÄNGE
METHOD FOR PRODUCING A GATE FOR A CMOS TRANSISTOR STRUCTURE HAVING A CHANNEL OF REDUCED LENGTH

(30) Priorité: 07.07.2000 FR 0008917
(43) Date de publication de la demande: 09.04.2003
(73) Titulaire: Commissariat à l'Énergie Atomique et aux Énergies Alternatives, 75015 Paris (FR); CENTRE NATIONAL DE LA RECHERCHE SCIENTIFIQUE -CNRS-, 75794 Paris Cedex 16 (FR)
(72) Inventeur: JOUBERT, Olivier, F-38240 Meylan (FR); CUNGE, Gilles, F-38600 Fontaine (FR); FOUCHER, Johann, F-38100 Grenoble (FR); FUARD, David, F-38000 Grenoble (FR); BONVALOT, Marceline, F-38330 Saint Ismier (FR); VALLIER, Laurent, F-38240 Meylan (FR)
(74) Mandataire: Ilgart, Jean-Christophe
(86) Numéro de dépôt international: PCT/FR2001/002180
(87) Numéro de publication internationale: WO 2002/005336

(56) Documents cités:
- EP-A- 0 050 973
- EP-A- 0 328 350
- US-A- 5 342 481
- US-A- 5 834 817
- PATENT ABSTRACTS OF JAPAN vol. 1995, no. 02, 31 mars 1995 (1995-03-31) -& JP 06 314674 A (SONY CORP), 8 novembre 1994 (1994-11-08)

## Description

### Domaine technique

La présente invention concerne un procédé de réalisation d'une grille pour une structure de transistor CMOS à canal de longueur réduite.

### Etat de la technique antérieure

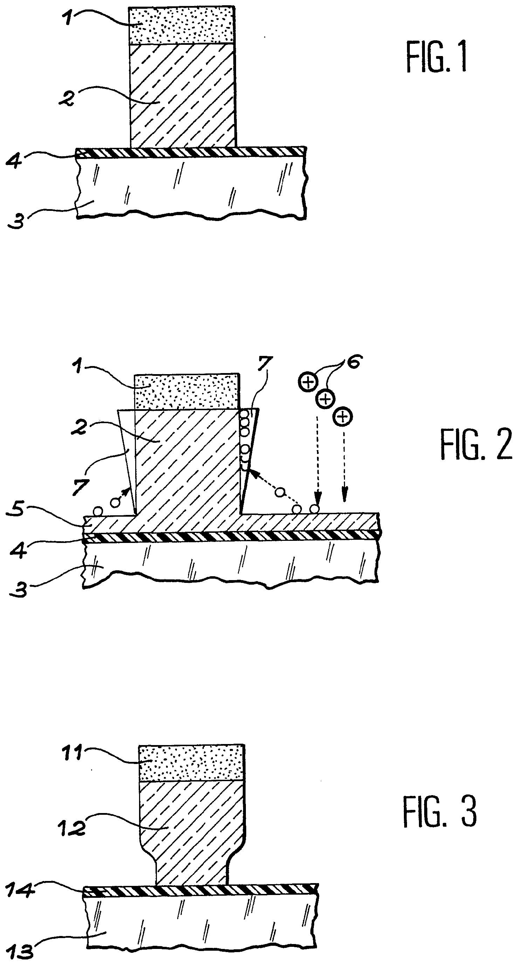

La grille en polysilicium est le coeur d'un dispositif CMOS. Dans une approche traditionnelle, la grille est obtenue par enchaînement d'une étape de photolithographie suivie d'une étape de gravure. L'étape de photolithographie permet de définir la dimension souhaitée dans un masque en résine. Puis, l'image obtenue dans la résine est transférée par plasma dans une couche de polysilicium ou de silicium amorphe généralement dopée. Cette étape est effectuée dans un réacteur de gravure à plasma haute densité. L'étape de fabrication de la grille est déterminante puisque c'est la dimension de la grille qui fixe la vitesse de fonctionnement du dispositif. En règle générale, on s'autorise une déviation en dimension qui ne doit pas excéder 10% de la dimension visée. Au cours de l'étape de gravure on s'efforce d'obtenir des flancs de gravure parfaitement droits (gravure anisotrope) de manière que la dimension du polysilicium au pied de la grille soit égale à la dimension du polysilicium au sommet de la grille, elle-même fixée au premier ordre par la dimension du masque. Ceci est illustré par la figure 1 qui montre, en coupe transversale, une partie d'une structure de transistor CMOS en cours de réalisation. Un masque de résine 1 (ou un masque dur) a permis la formation d'une grille 2 à partir d'une couche de polysilicium, de silicium amorphe ou d'un alliage SiGe déposée sur un substrat de silicium 3 recouvert d'une couche d'oxyde de grille 4.

Si la gravure de la grille est anisotrope, c'est donc l'étape de photolithographie qui permet d'obtenir la dimension de grille souhaitée. Cette approche est utilisée depuis plus de 40 ans en microélectronique. Ce sont les progrès de la lithographie qui permettent de diminuer la dimension des grilles des transistors et donc d'augmenter leur vitesse de fonctionnement.

La gravure d'une telle grille en polysilicium peut se faire par un enchaînement de plusieurs étapes de gravure différentes dont l'objectif est d'obtenir des flancs de gravure droits pour respecter aussi fidèlement que possible la cote définie par l'étape de lithographie. Le procédé comprend en général au moins trois étapes dont chacune a un rôle très précis.

La première étape est une étape de percement ("breakthrough" en anglais) qui permet d'éliminer l'oxyde natif présent à la surface du polysilicium avant la gravure. Cette étape est effectuée dans des conditions qui permettent d'éliminer au mieux cet oxyde natif : forte puissance de la source, forte polarisation du porte-substrat. Cette étape ne dure que quelques secondes car elle est peu sélective par rapport au masque de grille et entraîne donc sa consommation.

La deuxième étape, dite étape de gravure principale, permet de graver rapidement le polysilicium et de définir l'anisotropie de gravure. Elle est généralement effectuée avec des mélanges de gaz du type Cl₂/O₂, HBr/Cl_{2/}O₂ ou HBr/O₂. La présence d'oxygène dans la phase gazeuse du plasma permet de former des produits de gravure à base de silicium, d'oxygène et de brome ou de chlore en fonction du mélange utilisé. Ces produits de gravure se déposent sur les flancs du polysilicium pendant sa gravure. Ces produits non volatils ne se forment que lorsque l'énergie des ions qui bombardent le substrat est supérieure à 70-80 eV. La puissance de polarisation appliquée au porte-substrat doit donc être adaptée à la densité du plasma pour permettre la formation et la pulvérisation de ces produits de gravure. L'accumulation des produits de gravure déposés sur les flancs du polysilicium génère une couche de passivation qui protège les flancs du polysilicium d'une attaque chimique réactive spontanée par les espèces neutres du plasma (chlore atomique ou brome atomique ou chlore et brome atomique excités). Pour les plasmas du type Cl₂/O₂, HBr/ Cl₂/O₂ ou HBr/O₂, les analyses de surface par spectroscopie de photoélectrons X montrent que la couche de passivation qui se forme pendant l'étape de gravure principale est du type SiOₓCl_{y}Br_{z} avec x, y et z < 1. Elle peut être assimilée à un oxyde de silicium poreux sous-stoechiométrique en oxygène mais riche en brome (dans le cas d'une chimie HBr/O₂) ou en chlore (dans le cas d'une chimie Cl₂/O₂). Son épaisseur est plus importante au sommet de la grille (typiquement entre 5 et 10 nm) qu'au pied de la grille (de l'ordre de 1 à 2 nm) . L'épaisseur et la composition chimique de la couche de passivation dépendent du mélange des gaz de gravure et des conditions opératoires du plasma (puissance RF injectée dans la source, puissance de polarisation RF appliquée au porte-substrat, pression de travail, flux des gaz de gravure).

La figure 2 montre la formation d'une couche de passivation lors de la gravure de la couche de polysilicium. Cette figure montre la grille 2 de la figure 1 en cours de fabrication par gravure d'une couche de polysilicium 5. Sous l'action des ions 6 qui bombardent la couche de polysilicium avec une énergie suffisante, il se forme une couche de passivation 7 sur les flancs de la grille en cours de formation.

La troisième étape est l'étape de surgravure. Elle permet d'éliminer des résidus de polysilicium qui restent éventuellement après l'étape de gravure principale dans les lignes denses de polysilicium de petites dimensions. Sa durée est de l'ordre de 30 à 100% de la durée de l'étape de gravure principale. Lors de l'étape de surgravure, la puissance de polarisation appliquée au porte-substrat est diminuée par rapport à celle appliquée pendant l'étape de gravure principale (typiquement d'un facteur 2) de façon à ne pas endommager l'oxyde de grille qui protège le substrat de silicium d'éventuels dommages structuraux et électriques que peut engendrer le plasma. Pendant l'étape de surgravure, la couche de passivation n'est plus alimentée par les produits de gravure. La couche de passivation peut alors être érodée voire gravée complètement par les espèces actives du plasma (chlore atomique, brome atomique). Dans ce cas, le polysilicium se trouve exposé aux espèces actives. Les réactions de gravure spontanées qui en résultent peuvent générer des distorsions importantes des profils de gravure. Dans un procédé de gravure standard, pour que l'anisotropie de la gravure soit parfaite, la couche de passivation qui est formée pendant l'étape de gravure principale doit donc être assez résistante pour ne pas être totalement consommée pendant son exposition au plasma de surgravure.

L'étape de gravure principale peut éventuellement être séparée en deux étapes distinctes. Une première étape est identique à celle décrite précédemment. Elle est appliquée pendant environ les 2/3 ou les 4/5 de l'épaisseur de la couche de polysilicium. Pour graver l'épaisseur restante de polysilicium, la puissance RF de polarisation appliquée au porte-substrat est fortement diminuée, dans une gamme de valeur identique à celle appliquée pendant l'étape de surgravure, ce qui permet d'arriver sur l'oxyde de grille dans des conditions plasma douces (appelées "landing step" en anglais) permettant de minimiser sa consommation.

Le tableau I donne un exemple de mise en oeuvre du procédé de gravure pour un procédé comportant une étape de gravure principale en deux parties (gravure principale I et gravure principale II). On considère dans cet exemple que le plasma est une source haute densité inductive permettant de graver des substrats de taille 200 mm et que la puissance injectée dans la source est de l'ordre de 500 W. Il en résulte que la densité du plasma est de l'ordre de 10¹¹ ions/cm³. Les flux de gaz indiqués et pression de travail ne sont donnés qu'à titre d'exemple. Il est clair que les flux indiqués pour chaque gaz peuvent varier dans une gamme assez large. La valeur de la puissance RF, appelée P, appliquée au porte-substrat à chaque étape n'est qu'indicative. Ces valeurs sont différentes si la puissance injectée dans la source est différente.

Dans ce tableau, les flux de gaz sont exprimés en "sccm", c'est-à-dire en cm³ normaux/minute. La pression est exprimée en mTorr pour des raisons pratiques (1mTorr = environ 0,133 Pa).

**Tableau I**

| Etape | Chimie en phase gazeuse | Flux de gaz Pression | P (W) |
|---|---|---|---|
| Percement | C₂F₄ ou Cl₂ | 100 sccm quelques mTorr | P > 200 |
| Gravure principale I | HBr/Cl₂/O₂ | 150/30/5 sccm quelques mTorr | 80 < P < 150 |
| Gravure principale II | HBr/Cl₂/O₂ | 150/30/5 sccm quelques mTorr | 40 < P < 70 |
| Surgravure | HBr/O₂ | 150/10 sccm > 30 mTorr | 40 < P < 60 |

Depuis peu, on voit apparaître dans la littérature spécialisée des références à des structures de transistor CMOS à pied de grille entaillé. C'est le cas par exemple, de l'article "100 nm Gate Length High Performance/Low Power CMOS Transistor Structure" de T. GHANI et al. paru dans la revue IEDM 1999, pages 415 à 418. On obtient ainsi une grille dont la longueur au pied est inférieure à la longueur au sommet. C'est ce que montre la figure 3 où, par analogie avec la figure 1, la référence 11 désigne le masque, la référence 12 désigne la grille, la référence 13 désigne le substrat et la référence 14 désigne la couche d'oxyde de grille. La longueur électrique effective de la grille étant fixée par l'intersection entre le polysilicium et l'oxyde de grille, on obtient finalement une grille dont la dimension effective est inférieure à la dimension fixée par l'étape de photolithographie. Cette configuration est donc intéressante puisqu'elle permet d'aller au delà de la résolution fixée par la photolithographie.

On peut supposer que le profil de la grille représentée à la figure 3 est obtenue grâce à la gravure qui est d'abord anisotrope et qui devient ensuite fortement isotrope. Un problème qui peut alors se poser est celui du contrôle de l'érosion latérale du pied de grille de manière à obtenir un profil déterminé de gravure.

Le brevet US-A-5 834 817 divulgue un transistor à effet de champ à électrode de grille façonnée, cette grille ayant une longueur plus petite à son pied qu'à son sommet. Un empilement est constitué sur une face en matériau semi-conducteur d'un substrat, l'empilement comprenant successivement une couche d'isolant de grille , une couche de matériau de grille et un masque de grille. Le procédé comprend les étapes suivantes :
- gravure anisotrope de la partie supérieure de la couche de matériau de grille non masquée par le masque de grille, cette étape de gravure laissant subsister la partie inférieure de la couche de matériau de grille et entraînant la formation, sur les flancs de gravure résultant de la gravure anisotrope, d'un dépôt constitué de produits de gravure,
- gravure, jusqu'à la couche d'isolation de grille, de la partie inférieure de la couche de matériau de grille, cette gravure comprenant une gravure isotrope de la couche de matériau de grille pour conférer à la grille une longueur plus petite à son pied qu'à son sommet.

Le document Patent Abstracts of Japan, Vol. 1995, N°02, 31 mars 1995, relatif à JP-A-06 314 674, divulgue un procédé de fabrication d'une électrode de grille. Un substrat est recouvert d'une couche d'oxyde de grille, d'une couche de silicium polycristallin, d'une couche de WSi₂ et d'un masque. On procède à la gravure de l'électrode de grille. La couche de WSi₂ est d'abord gravée, puis la couche de silicium polycristallin. Un produit de réaction constitué de SiBrₓO_{y} se dépose sur les parois de l'électrode de grille. Un traitement par plasma d'hydrogène est réalisé pour modifier le dépôt de produit de réaction. Les atomes de brome sont remplacés par des atomes d'hydrogène. Le dépôt peut ensuite être éliminé au moyen d'acide fluorhydrique.

Le document EP-A-0 050 973 divulgue un procédé de masquage pour dispositifs semi-conducteurs utilisant un film de polymère fluorocarboné. Ce film est déposé en mettant en oeuvre un plasma du type CₓF_{y}H_{z}.

Le document EP-A-0 328 350 divulgue un procédé de gravure sèche d'un matériau tel que le silicium polycristallin ou un siliciure grâce à du bromure d'hydrogène ou du brome. Il divulgue qu'une gravure plasma utilisant comme gaz de gravure Br ou HBr permet un contrôle précis de la gravure. Il divulgue aussi qu'un gaz de gravure contenant du carbone peut provoquer le dépôt, sur la paroi de la chambre de gravure, d'un polymère.

Le document US-A-5 342 481 divulgue un procédé de gravure sèche permettant d'obtenir une gravure anisotrope d'une couche de matériau sans perte dimensionnelle même si le masque de photorésist présente un profil de forme effilée inversée. Le procédé permet d'obtenir des parois verticales pour un masque de photorésist, ce qui permet par la suite d'obtenir une gravure anisotrope du matériau à graver.

### Exposé de l'invention

Il est proposé selon la présente invention d'usiner la couche de passivation qui se forme pendant la gravure de la grille pour lui donner un profil de gravure anisotrope à son sommet et très largement isotrope au pied de la grille.

L'invention a donc pour objet un procédé de réalisation d'une grille pour une structure de transistor CMOS dont la longueur de la grille est plus petite au pied de la grille qu'au somment de la grille, à partir d'un empilement constitué sur une face en matériau semi-conducteur d'un substrat, ledit empilement comprenant successivement une couche d'isolant de grille, une couche de matériau de grille et un masque de grille, le procédé comprenant les étapes décrites dans la revendication 1. constitué de produits de gravure, caractérisé, en ce que.

Selon un premier mode de réalisation l'étape c) comprend deux sous-étapes :
- d'abord une étape de gravure anisotrope de la partie inférieure de la couche de matériau de grille jusqu'à la couche d'isolant de grille,
- ensuite une étape consistant à soumettre l'empilement à un plasma de surgravure qui provoque ladite gravure isotrope.

Selon un deuxième mode de réalisation l'étape c) est constituée par la soumission de l'empilement à un plasma de surgravure permettant à la fois d'atteindre la couche d'isolant de grille et de conférer à la grille ladite longueur plus petite à son pied qu'à son sommet.

La gravure isotrope de la couche de matériau de grille peut être réalisée au moyen d'espèces réactives réagissant avec le matériau de grille en l'absence de plasma.

Selon l'invention le dépôt constitué de produits de gravure étant SiOₓCl_{y}Br_{z} avec x, y et z < 1 et y ou z pouvant être égal à 0, l'étape b) consiste à substituer le chlore et le brome du dépôt constitué de produits de gravure par de l'oxygène. Dans ce cas, la substitution du chlore et du brome est effectuée grâce à un plasma de gaz comprenant au moins un gaz à base d'oxygène. Le gaz à base d'oxygène peut être choisi parmi les gaz suivants : O₂, O₃, H₂O, N₂O, NO, CO, CO₂, SO₂ ou SO₃. Le plasma de gaz peut comprendre aussi au moins un gaz choisi parmi Ar, Xe, Kr, NH₃ et N₂. Dans ce cas, l'étape b) peut avantageusement se dérouler en ayant placé le substrat sur un porte-substrat non polarisé.

L'invention s'applique notamment à la réalisation d'une grille en un matériau à base de silicium.

Elle s'applique également à la réalisation d'une grille du type métallique, la couche de matériau de grille comprenant une sous-couche à base de matériau semi-conducteur formant la partie supérieure de la couche de matériau de grille et une sous-couche métallique formant la partie inférieure de la couche de matériau de grille.

### Brève description des dessins.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1, déjà décrite, représente, en coupe transversale, une partie d'une structure de transistor CMOS selon l'art connu en cours de réalisation,
- la figure 2, déjà décrite, montre la formation d'une couche de passivation lors d'une étape de gravure d'une couche de matériau de grille selon l'art connu,
- la figure 3, déjà décrite, représente, en coupe transversale, une partie d'une structure de transistor CMOS selon une récente proposition de l'art connu,
- les figures 4A à 4D sont des vues en coupe transversale illustrant des étapes d'un procédé de réalisation d'une structure de transistor CMOS selon l'invention,
- les figures 5A à 5C sont des vues en coupe transversale illustrant des étapes d'un procédé de réalisation d'une deuxième structure de transistor CMOS selon l'invention.

### Description détaillée de modes de réalisation de l'invention.

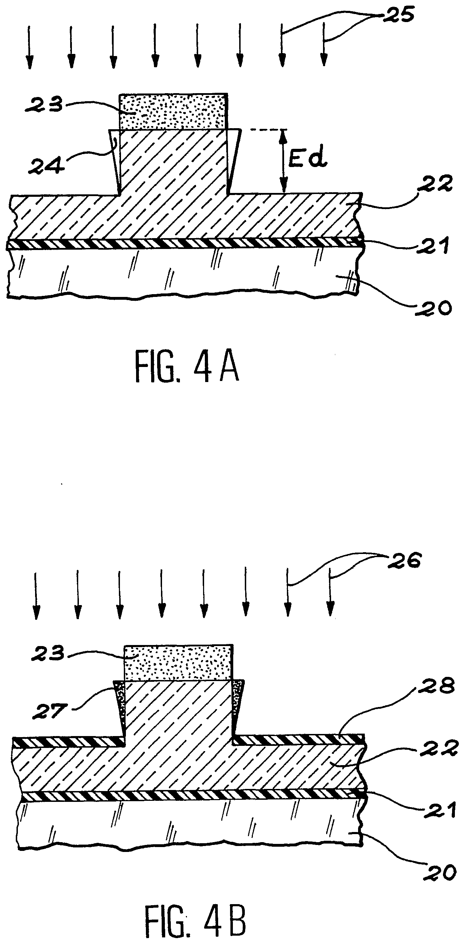

La réalisation d'une première structure de transistor CMOS, selon l'invention, va maintenant être décrite en relation avec les figures 4A à 4D.

La figure 4A montre un substrat de silicium 20 supportant successivement une couche d'oxyde de silicium 21, une couche de matériau de grille 22 (par exemple en polysilicium ou en silicium amorphe) et un masque de résine 23. Cette figure représente l'état de la structure au cours de l'étape de gravure anisotrope de la partie supérieure de la couche de matériau de grille 22. Il se forme, sur les flancs de la grille en cours de réalisation, un dépôt 24 (ou couche de passivation) constitué de produits de gravure. Si le plasma de gravure 25 est un plasma HBr/Cl_{2/}O₂, le dépôt 24 est du type SiOₓCl_{y}Br_{z} avec x, y et z < 1. Cette couche de passivation 24 protège les flancs de la grille pendant la gravure. Elle est plus épaisse au sommet qu'en bas de grille et elle présente une certaine porosité et sous-stoechiométrie en oxygène qui la fragilise. La couche 24 est formée sur une profondeur Ed par le dépôt des produits de gravure sur les flancs de la grille en cours de constitution. L'étape de gravure qui permet de créer cette couche est par exemple l'étape de gravure principale I du tableau I.

La couche de passivation 24 est renforcée par une exposition à un plasma à base d'oxygène 26 (voir la figure 4B). Cette exposition permet de substituer le chlore et le brome présents dans la couche 24 par de l'oxygène. Cette étape permet de transformer la couche de passivation en une couche de protection 27 constituée de matériau du type SiOₓ plus dense que la couche d'origine et donc plus résistante à une étape postérieure de gravure.

Les mélanges de gaz permettant de renforcer la couche de passivation en l'oxydant sont les mélanges à base d'oxygène. Les gaz suivants peuvent permettre d'effectuer cette opération : O₂, O₃, H₂O, N₂O, NO, CO, CO₂, SO₂, SO₃. Ces gaz peuvent être mélangés à des gaz neutres comme Ar, Xe, Kr, et à des gaz du type NH₃ ou N₂. Pour réaliser l'oxydation de la couche de passivation, un plasma haute densité fortement dissocié permettra de générer de fortes concentrations d'oxygène atomique dans la phase gazeuse. L'oxydation de la couche de passivation est d'autant plus efficace que la puissance injectée dans le plasma est élevée. Cette technique présente l'inconvénient d'oxyder la surface du matériau de grille (couche d'oxyde 28) qui reste à graver, ce qui nécessitera une étape de percement dans la suite du procédé. Pour minimiser l'oxydation de la surface du matériau de grille, il est nécessaire de ne pas appliquer de polarisation au porte-substrat pendant l'oxydation de la couche de passivation.

Une autre solution, qui ne fait pas partie de la présente invention, pour renforcer la couche de passivation consiste à l'exposer à un plasma CₓF_{y}H_{z} qui permet de déposer une couche de polymère fluorocarboné sur les flancs de gravure. Tous les gaz du type CₓF_{y}H_{z} utilisés pour la gravure du SiO₂ peuvent être employés : C₂F₆, C₄F₈, C₂F₄, C₃F₆, CHF₃, CH₃F, etc... Dans le cas d'un plasma CₓF_{y}H_{z}, on doit s'efforcer d'éviter le dépôt d'un film de polymère sur la surface du matériau de grille 22. Pour cela, le porte-substrat qui supporte le substrat 20 est polarisé de manière à éviter le dépôt de polymère sur cette surface et de manière à ne pas graver le matériau de grille. La puissance de polarisation RF appliquée pour minimiser la consommation de matériau de grille dépend de la densité du plasma (donc de la puissance RF injectée dans la source) et de la nature du gaz CₓF_{y}H_{z}.

Deux approches peuvent être envisagées pour la poursuite du procédé.

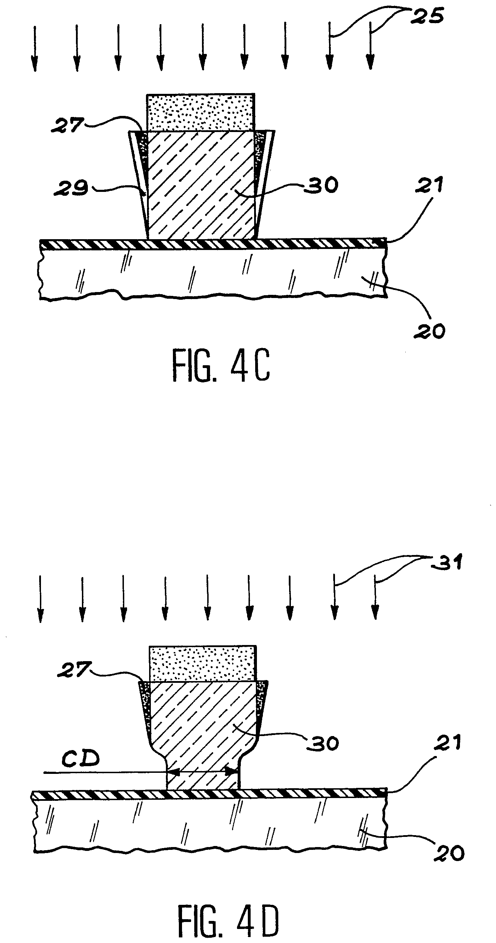

Une première approche consiste à poursuivre la gravure anisotrope de la couche de matériau de grille 22 jusqu'à la couche d'isolant de grille 21. C'est ce que montre la figure 4C. Auparavant, une étape de percement a permis d'éliminer la couche d'oxyde 28 (voir la figure 4B) qui s'était formée lors de la réalisation de la couche de protection 27 dans le cas du renforcement de la couche de passivation par de l'oxygène. Dans le cas où le renforcement de la couche de passivation s'obtient par un dépôt de polymère, l'étape de percement permet d'éliminer le polymère qui se forme à la surface de la couche de matériau de grille 22. Cette étape de percement est suivie d'une étape de gravure anisotrope de la couche de matériau de grille jusqu'à la couche d'isolant de grille 21 grâce au même plasma 25 qui a servi à graver la partie supérieure de la couche de matériau de la grille. Il s'ensuit la formation d'une autre couche de passivation 29 sur les flancs de la grille 30 ainsi délimitée. Cette couche 29 se superpose en partie haute de la grille 30 à la couche de protection 27. Des conditions plasma particulières peuvent empêcher la formation de la couche de passivation 29 en éliminant l'oxygène et le brome de la phase gazeuse du plasma.

La grille 30 est alors exposée à un plasma de surgravure 31 qui permet d'usiner latéralement la grille à l'endroit où la couche de passivation 29 n'est pas renforcée (voir figure 4D). La durée de cette étape permet de régler l'amplitude de la gravure latérale (gravure isotrope) sans perturber l'anisotropie du profil sur toute l'épaisseur où la couche de passivation a été renforcée. C'est donc la durée de cette étape qui va permettre de contrôler la longueur CD du pied de la grille. L'étape de surgravure est parfaitement sélective par rapport à la couche d'isolant de grille 21. Elle est aussi parfaitement sélective par rapport à la couche de protection 27 formée sur les flancs de la grille 30.

Une deuxième approche consiste, lorsque la couche de passivation a été renforcée et l'étape de percement réalisée, à mettre en oeuvre immédiatement l'étape de surgravure pour démarrer une érosion latérale contrôlée du pied de grille. On passe ainsi directement de l'étape représentée à la figure 4B à l'étape représentée à la figure 4D. Cette approche présente l'avantage important que l'arrivée sur la couche d'isolant de grille se fait dans des conditions opératoires du plasma qui sont très douces. Cependant, le contrôle final de la longueur CD du pied de grille est plus délicat avec cette approche car la longueur finale est contrôlée par le rapport entre les vitesse de gravure verticale et latérale du matériau de grille. Dans la première approche au contraire, seule la vitesse de gravure intervient pour le contrôle de la longueur CD. Par ailleurs, des effets de charges peuvent modifier la vitesse d'érosion latérale lorsque le matériau de grille est complètement dégagé sur l'isolant de grille. Cette approche n'en reste pas moins réaliste pour réduire la dimension de la grille par rapport à la cote définie par l'étape de lithographie.

Le tableau II donne un exemple de mise en oeuvre du procédé selon l'invention pour un substrat en silicium supportant une couche d'oxyde de grille en polysilicium. Cet exemple se rapporte à la première approche avec une couche de passivation renforcée par un plasma à base d'oxygène. On considère dans cet exemple que le plasma est une source haute densité inductive permettant de graver des substrats de taille 200 mm et que la puissance injectée dans la source est de l'ordre de 500 W. Il en résulte que la densité du plasma est de l'ordre de 10¹¹ions/cm³. Les flux de gaz et pression de travail indiqués ne sont donnés qu'à titre d'exemple. Les flux indiqués pour chaque gaz peuvent varier dans une gamme assez large. La valeur de la puissance RF appliquée au porte-substrat à chaque étape n'est qu'indicative. Ces valeurs sont différentes si la puissance injectée dans la source est différente.

**Tableau II**

| Etape | Chimie en phase gazeuse | Flux de gaz Pression | P (W) |
|---|---|---|---|
| Percement | C₂F₄ ou Cl₂ | 100 sccm quelques mTorr | 150 < P < 200 |
| Gravure principale I | HBr/Cl₂/O₂ | 150/30/5 sccm quelques mTorr | 80 < P < 150 |
| Renforcement | O₂ | 150 sccm > 15 mTorr | P=0 |
| Percement | Cl₂ | 100 sccm quelques mTorr | 150 < P < 200 |
| Gravure principale II | HBr/Cl₂/O₂ | 150/30/5 sccm quelques mTorr | 50 < P < 80 |
| Surgravure | HBr/O₂ | 150/10 sccm > 30 mTorr | 40 < P < 60 |

Il est possible également d'utiliser des gaz réactifs qui, en l'absence de plasma, peuvent réagir spontanément avec le matériau de grille pour obtenir l'érosion latérale du pied de grille.

En effet, en règle générale le plasma permet de produire des espèces réactives chimiquement actives et électriques (ions et électrons) qui participent à la gravure. L'anisotropie de gravure résulte de la synergie entre les ions et les espèces neutres du plasma, le bombardement ionique permettant d'accélérer notablement les cinétiques de gravure chimique dues aux espèces neutres. Lors de la gravure latérale du pied de grille, l'érosion latérale du matériau de grille est produite par les espèces neutres du plasma qui réagissent spontanémant avec le matériau de grille pour former des produits de réactions volatils. Les ions du plasma ne jouent aucun rôle dans cette attaque chimique latérale puisqu'ils arrivent verticalement et non pas directement sur les flancs de la grille qui sont érodés par les espèces neutres.

Au cours de cette étape de gravure latérale, le bombardement ionique et électronique dû au plasma peut compliquer le procédé. En effet, il faut éviter d'endommager la couche d'isolant de grille qui est bombardée par des ions énergétiques du plasma pendant l'étape d'érosion latérale du pied de grille. La sélectivité de gravure entre le matériau de grille et l'isolant de grille peut alors devenir trop faible pour éviter l'endommagement des futures zones actives du transistor. Par ailleurs, le champ électrique du plasma peut être suffisamment élevé pour que, au cours de cette étape d'érosion latérale, des ions du plasma soient directement implantés dans le substrat à travers la couche d'isolant de grille. Enfin, la différence de directionnalité entre les ions et les électrons du plasma peut produire des effets de charge provoquant des courants d'électrons dans la couche d'isolant de grille lors du déroulement du procédé et pouvant conduire à la dégradation de cet isolant. Il résulte de ceci qu'une étape d'érosion latérale de la grille en absence de plasma présente des avantages certains.

La gravure isotrope de la couche de matériau de grille peut donc être réalisée au moyen d'espèces réactives réagissant avec le matériau de grille en l'absence de plasma.

Les gaz à base de fluor sont des candidats très intéressants pour réaliser une gravure isotrope d'une grille en matériau à base de silicium (silicium amorphe ou polysilicium), la couche d'isolant de grille étant en oxyde de silicium. A température ambiante, le rapport des vitesse de gravure, par le fluor atomique, entre le silicium et l'oxyde de silicium est de 44. A 100°C, ce rapport vaut 25. Il est donc particulièrement intéressant de pouvoir produire une source de fluor atomique en l'absence de plasma puisqu'une gravure spontanée du silicium devient possible en l'absence de consommation d'oxyde de grille. Cette gravure latérale permet d'éroder le silicium des flancs de la grille sans consommer d'oxyde de grille et sans risque de création de défauts structuraux ou électriques dans le silicium. Pour que ceci puisse être réalisé, il est donc nécesaire de sélectionner des gaz qui, en l'absence de plasma, se dissocient spontanément à la surface du silicium pour produire une source de fluor atomique. Des gaz comme XeF₂ ou F₂ sont de bons candidats puisque ces gaz gravent efficacement le silicium en l'absence de plasma.

Par ailleurs, la vitesse d'érosion latérale dépendant de la pression partielle de gaz (XeF₂ ou F₂) dans le réacteur et de la température du substrat, il est possible de contrôler de manière extrêmement précise la vitesse d'érosion latérale et donc la dimension finale au pied de grille pour obtenir des profils de gravure du type représenté à la figure 4D.

L'invention s'applique également aux cas des structures à grille métallique. Les grille métalliques sont potentiellement intéressantes pour les filières de la micro-électronique du futur. Elles présentent cependant l'inconvénient d'être très difficilement intégrables dans les filières technologiques. L'étape de gravure est en particulier particulièrement difficile à mettre au point car anisotropie de gravure et intégrité de l'oxyde de grille sont très difficiles à concilier dans le cas des métaux. Cependant, dans le cas d'une couche de matériau de grille constituée d'un empilement de matériau semi-conducteur sur du métal, l'invention s'avère particulièrement intéressante.

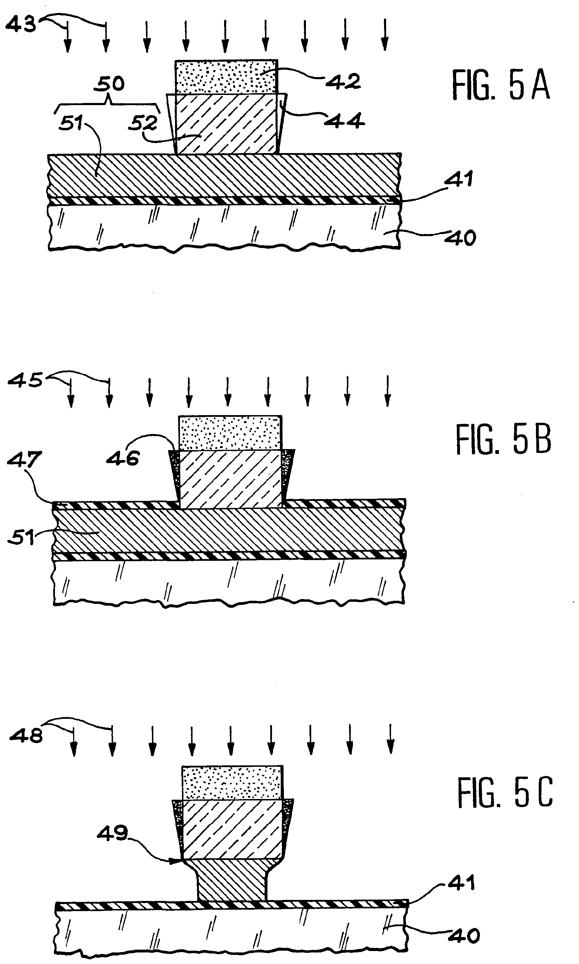

Les figures 5A à 5C illustrent l'application de l'invention au cas d'une grille métallique.

La figure 5A montre un substrat de silicium 40 supportant successivement une couche d'oxyde de silicium 41, une couche de matériau de grille 50 et un masque de résine 42. La couche de matériau de grille 50 comprend une sous-couche inférieure 51 métallique, par exemple en Al, W ou TiN, et une sous-couche supérieure 52, par exemple en polysilicium ou en silicium amorphe. La figure 5A représente l'état de la structure au cours de l'étape de gravure anisotrope de la sous-couche supérieure 52 par un plasma 43. Il se forme, sur les flancs de la grille en cours de réalisation, un dépôt 44 constitué de produits de gravure. Le plasma de gravure 43 est par exemple du type HBᵣ/Cl₂/O₂.

Comme précédemment, la couche de passivation est renforcée au moyen d'un plasma 45 à base d'oxygène pour fournir une couche de protection 46 (voir la figure 5B). Comme précédemment également le renforcement de la couche de passivation peut être obtenu par un polymère fluorocarboné. La figure 5B montre que le plasma à base d'oxygène a oxydé la surface de la sous-couche métallique 51 pour produire une couche d'oxyde 47.

Après une étape de percement de la couche d'oxyde 47, la sous-couche métallique 51 est gravée au moyen d'un plasma de gravure 48 qui provoque une gravure isotrope tout en permettant de préserver la couche d'oxyde de grille 41. La durée de cette étape permet d'obtenir la dimension visée au pied de la grille. Cette approche est particulièrement adaptée au cas de grilles métalliques puisque naturellement ces matériaux se gravent de manière isotrope. On obtient une grille 49 comprenant une partie inférieure métallique et une partie supérieure en matériau semi-conducteur.

## Revendications

1. Procédé de réalisation d'une grille (30,49) pour une structure de transistor CMOS dont la longueur de la grille est plus petite au pied de la grille qu'au sommet de la grille, à partir d'un empilement constitué sur une face en matériau semi-conducteur d'un substrat (20,40), ledit empilement comprenant successivement une couche d'isolant de grille (21,41), une couche de matériau de grille (22,51,52) et un masque de grille (23,42), le procédé comprenant les étapes suivantes :
a) gravure anisotrope de la partie supérieure de la couche de matériau de grille non masquée par le masque de grille (23,42), cette étape de gravure laissant subsister la partie inférieure de la couche de matériau de grille et entraînant la formation, sur les flancs de gravure résultant de la gravure anisotrope, d'un dépôt (24,44) constitué de produits de gravure du type SiOₓCl_{y}Br_{z} avec x, y et z <1,
c) gravure, jusqu'à la couche d'isolant de grille (21,41), de la partie inférieure de la couche de matériau de grille, cette gravure comprenant une gravure isotrope de la couche de matériau de grille pour conférer à la grille (30,49) une longueur plus petite à son pied qu'à son sommet,
**caractérisé en ce que**, entre les étapes a) et b), est exécutée une étape b) d'exposition à un plasma contenant au moins un gaz à base d'oxygène du dépôt (24,44) des produits de gravure permettant de subsituer le chlore et le brome présents dans ladite couche (24, 44) par de l'oxygène, et pour en faire une couche de protection (27,46) en SiOx plus dense que la couche d'origine et renforcée vis-à-vis de la gravure de l'étape c), de sorte que la couche de protection (27,46) est plus résistante que le dépôt (24,44) des produits de gravure vis-à-vis de la gravure de l'étape c) .

2. Procédé selon la revendication 1, **caractérisé en ce que** l'étape c) comprend deux sous-étapes :
- d'abord une étape de gravure anisotrope de la partie inférieure de la couche de matériau de grille jusqu'à la couche d'isolant de grille,
- ensuite une étape consistant à soumettre l'empilement à un plasma de surgravure qui provoque ladite gravure isotrope.

3. Procédé selon la revendication 1, **caractérisé en ce que** l'étape c) est constituée par la soumission de l'empilement à un plasma de surgravure (31) permettant à la fois d'atteindre la couche d'isolant de grille (21) et de conférer à la grille (30) ladite longueur plus petite à son pied qu'à son sommet.

4. Procédé selon la revendication 1, **caractérisé en ce que** la gravure isotrope de la couche de matériau de grille est réalisée au moyen d'espèces réactives réagissant avec le matériau de grille en l'absence de plasma.

5. Procédé selon l'une quelconque des revendication 1 à 4, **caractérisé en ce que** le gaz à base d'oxygène est choisi parmi les gaz suivant : O₂, O₃, H₂O, N₂O, NO, CO, CO₂, SO₂ ou SO₃.

6. Procédé selon la revendication 5, **caractérisé en ce que** le plasma de gaz comprend aussi au moins un gaz choisi parmi Ar, Xe, Kr, NH₃ et N₂.

7. Procédé selon l'une quelconque des revendications 1 à 6, **caractérisé en ce que** la grille (30) est en un matériau à base de silicium.

8. Procédé selon l'une quelconque des revendications 1 à 7, **caractérisé en ce que** la grille (49) est du type métallique, la couche de matériau de grille (50) comprenant une sous-couche à base de matériau semi-conducteur (52) formant la partie supérieure de la couche de matériau de grille et une sous-couche métallique (51) formant la partie inférieure de la couche de matériau de grille.

## Patentansprüche

1. Verfahren zum Herstellen eines Gates (30, 49) für eine CMOS-Transistorstruktur, bei dem die Gate-Länge am Fuße des Gates kleiner ist als am Kopf des Gates, ausgehend von einer Stapelung, die auf einer Seite aus einem Halbleitermaterial eines Substrats (20, 40) besteht, wobei die Stapelung nacheinander eine Gate-Isolatorschicht (21, 41), eine Gate-Materialschicht (22, 51, 52) und eine Gate-Maske (23, 42) enthält, wobei das Verfahren die folgenden Schritte umfasst:
a) anisotropes Ätzen des durch die Gate-Maske (23, 42) nicht maskierten oberen Teils der Gate-Materialschicht, wobei bei diesem Schritt des Ätzens der untere Teil der Gate-Materialschicht bestehen bleibt und die Bildung einer Abscheidung (24, 44), die aus Ätzprodukten des Typs SiOₓCl_{y}Br_{z} mit x, y und z < 1 besteht, an den aus dem anisotropen Ätzen resultierenden Ätzflanken bewirkt wird,
c) Ätzen des unteren Teils der Gate-Materialschicht bis zur Gate-Isolatorschicht (21, 41), wobei dieses Ätzen ein isotropes Ätzen der Gate-Materialschicht umfasst, um dem Gate (30, 49) eine geringere Länge an seinem Fuß als an seinem Kopf zu verleihen,
**dadurch gekennzeichnet, dass** zwischen den Schritten a) und b) ein Schritt b) des Aussetzens der Abscheidung (24, 44) aus Ätzprodukten einem Plasma erfolgt, das zumindest ein sauerstoffbasiertes Gas enthält, wodurch das in der Schicht (24, 44) vorhandene Chlor und Brom durch Sauerstoff ersetzt werden kann, und um daraus eine Schutzschicht (27, 46) aus SiOx zu bilden, die dichter als die ursprüngliche Schicht und gegenüber dem Ätzen von Schritt c) verstärkt ist, so dass die Schutzschicht (27, 46) gegenüber dem Ätzen von Schritt c) widerstandsfähiger als die Abscheidung (24, 44) aus Ätzprodukten ist.

2. Verfahren nach Anspruch 1, **dadurch gekennzeichnet, dass** der Schritt c) zwei Unterschritte umfasst:
- zunächst einen Schritt des anisotropen Ätzens des unteren Teils der Gate-Materialschicht bis auf die Gate-Isolatorschicht,
- dann einen Schritt, der darin besteht, die Stapelung einem Überätzungsplasma auszusetzen, welches das isotrope Ätzen bewirkt.

3. Verfahren nach Anspruch 1, **dadurch gekennzeichnet, dass** der Schritt c) aus dem Unterwerfen der Stapelung einem Überätzungsplasma (31) besteht, wodurch zugleich die Gate-Isolatorschicht (21) erreicht wird und dem Gate (30) die Länge verliehen werden kann, die an seinem Fuße geringer ist als an seinem Kopf.

4. Verfahren nach Anspruch 1, **dadurch gekennzeichnet, dass** das isotrope Ätzen der Gate-Materialschicht mittels von reaktiven Spezies erfolgt, die bei fehlendem Plasma mit dem Gate-Material reagieren.

5. Verfahren nach einem der Ansprüche 1 bis 4, **dadurch gekennzeichnet, dass** das sauerstoffbasierte Gas ausgewählt ist aus den folgenden Gasen: O₂, O₃, H₂O, N₂O, NO, CO, CO₂, SO₂ oder SO₃.

6. Verfahren nach Anspruch 5, **dadurch gekennzeichnet, dass** das Gasplasma auch zumindest ein Gas, ausgewählt aus Ar, Xe, Kr, NH₃ und N₂, enthält.

7. Verfahren nach einem der Ansprüche 1 bis 6, **dadurch gekennzeichnet, dass** das Gate (30) aus einem siliziumbasierten Material besteht.

8. Verfahren nach einem der Ansprüche 1 bis 7, **dadurch gekennzeichnet, dass** das Gate (49) vom metallischen Typ ist, wobei die Gate-Materialschicht (50) eine Unterschicht auf Basis von Halbleitermaterial (52) enthält, die den oberen Teil der Gate-Materialschicht bildet, sowie eine metallische Unterschicht (51), die den unteren Teil der Gate-Materialschicht bildet.

## Claims

1. Process for making a gate (30, 49) for a CMOS transistor structure for which the gate length is shorter at the bottom than at the top, made from a stack realized on a face in a semi-conducting material of a substrate (20, 40), said stack comprising a gate isolation layer (21, 41), a gate material layer (22, 51, 52) and a gate mask (23, 42) in sequence, the process comprising the following steps:
a) anisotropic etching of the top part of the gate material layer not masked by the gate mask (23, 42), this etching step leaving the bottom part of the gate material layer and leading to the formation of a deposit (24, 44) composed of etching products on the etching sides resulting from the anisotropic etching of SiOₓCl_{y}Br_{z} type, with x, y and z <1,
c) etching of the bottom part of the gate material layer (21, 41) as far as the gate isolation layer, this etching comprising isotropic etching of the gate material layer to make to the gate (30, 49) a length shorter at the bottom than at the top,
**characterised in that** there is a step b) between steps a) and c), a step b) of exposure to an oxygen based plasma is executed of the deposit (24, 44) composed of etching products, in order to substitute chlorine and brome present in said layer (24, 44) by oxygen, and to make a protection layer (27, 46) made of SiOx denser than the original layer and reinforced against etching in step c), and so that the protection layer (27, 46) is more resistant than the deposit composed of etching products against etching in step c).

2. Process according to claim 1, **characterised in that** step c) comprises two sub-steps:
- firstly, an anisotropic etching step of the lower part of the gate material layer as far as the gate isolation layer,
- then a step consisting of submitting the stack to an over-etching plasma that causes said isotropic etching.

3. Process according to claim 1, **characterised in that** step c) consists of applying an over etching plasma (31) to the stack to reach the gate isolation layer (21) and to make to said gate (30) a length shorter at the bottom than at the top.

4. Process according to claim 1, **characterised in that** the isotropic etching of the gate material layer is done using reactive species reacting with the gate material in the absence of a plasma.

5. Process according to any one of to claims 1 to 4, **characterised in that** the gas based on oxygen is chosen from among O₂, O₃, H₂O, N₂O, NO, CO, CO₂, SO₂ or SO₃.

6. Process according to claim 5, **characterised in that** the gas plasma also comprises at least one gas chosen from among Ar, Xe, Kr, NH₃ and N₂.

7. Application of the process according to any one of claims 1 to 6, for making a gate (30) from a silicon-based material.

8. Application of the process according to any one of claims 1 to 7, for making a metallic type gate (49), the layer of gate material (50) comprising a sub-layer based on a semi-conducting material (52) forming the upper part of the gate material layer and a metallic sub-layer (51) forming the lower part of the gate material layer.
